Europäisches Patentamt

European Patent Office

Office européen des brevets

(11) Publication number: **0 083 482**

**B1**

# EUROPEAN PATENT SPECIFICATION

(45) Date of publication of patent specification: 23.04.86

(21) Application number: **82306641.0**

(22) Date of filing: **13.12.82**

(51) Int. Cl.⁴: **H 03 K 19/017,**
**H 03 K 19/094, G 11 C 8/00**

(54) Improvements in logic circuit operation speed.

(30) Priority: **14.12.81 JP 201077/81**

(43) Date of publication of application:
**13.07.83 Bulletin 83/28**

(45) Publication of the grant of the patent:
**23.04.86 Bulletin 86/17**

(84) Designated Contracting States:
**DE FR GB**

(56) References cited:
**US-A-3 651 342**
**US-A-3 943 551**
**US-A-4 074 150**

(73) Proprietor: **FUJITSU LIMITED**
**1015, Kamikodanaka Nakahara-ku**
**Kawasaki-shi Kanagawa 211 (JP)**

(72) Inventor: **Seki, Teruo**
**Fujitsu Shimonoge-ryo 340 878, Shimonoge**
**Takatsu-ku Kawasaki-shi Kanagawa 213 (JP)**
Inventor: **Aoyama, Keizo**
**11-28, Tsukimino 1-chome**
**Yamato-shi Kanagawa 242 (JP)**
Inventor: **Yamauchi, Takahiko**
**Iseya-so, 2F-1 49, Kitaya-cho**
**Nakahara-ku Kawasaki-shi Kanagawa 211 (JP)**

(74) Representative: **Skone James, Robert Edmund**
**et al**
**GILL JENNINGS & EVERY 53-64 Chancery Lane**
**London WC2A 1HN (GB)**

The file contains technical information
submitted after the application was filed and
not included in this specification

Courier Press, Leamington Spa, England.

## Description

The present invention relates to logic circuits such as NAND circuits or NOR circuits. Such, logic circuits are often used in address decoders, bit line control clock generator circuits, and the like of a memory device.

A prior art logic circuit such as a NAND circuit or a NOR circuit comprises a load, a single driver circuit driven by the potentials at two or more input terminals, and an output terminal connected between the load and the driver circuit. The driver circuit has a plurality of gates which are driven by the potentials at the input terminals. Logic circuits similar to that described are illustrated in US—A—4,074,150.

In the above-mentioned prior art, however, the presence or absence of charges at an intermediate node of the gates generates a fluctuation in operation speed. In this case, the operation speed is dependent upon the condition of the input signals. As a result the overall operation speed is substantially reduced.

According to the present invention, a logic circuit comprises a first power supply; a second power supply; a plurality of input terminals; an output terminal; a load means connected between the first power supply and the output terminal; and at least two driver circuits connected in parallel between the second power supply and the output terminal, each of the driver circuits comprising a plurality of transistors of the same polarity connected in series, and each of the transistors being driven by the potential at one of the input terminals, wherein transistors of the driver circuits connected directly to the output terminal are driven by the potentials at different input terminals, and is characterised in that the number of transistors in each driver circuit is the same as the number of input terminals; in that each input terminal is connected to transistors in at least two driver circuits at different positions in the driver circuits; and in that each driver circuit provides the same logical response to potentials at the input terminals.

Preferably, the same number of driver circuits is provided as input terminals. With this arrangement at least one of the driver circuits operates rapidly in response to changes of input signals so as to change the potential at the output terminal. As a result, no fluctuation in operation speed is generated under any conditions of input signals, and, in addition, the operation speed is increased.

Some examples of logic circuits and memory device circuits incorporating logic circuits in accordance with the present invention will now be described and contrasted with the prior art with reference to the accompanying drawings, in which:—

Figure 1 is a circuit diagram illustrating a prior art logic circuit;

Figures 2A to 2D and Figures 3A to 3D are timing diagrams of the signals appearing in the circuit of Figure 1;

Figure 4 is a circuit diagram illustrating another prior art logic circuit;

Figures 5A to 5D and Figures 6A to 6D are timing diagrams of the signals appearing in the circuit of Figure 4;

Figures 7A to 7D, Figures 8A to 8D, Figures 9A and 9B, and Figures 10A and 10B are circuit diagrams illustrating examples of logic circuits according to the present invention;

Figure 11 is a block circuit diagram illustrating a random access memory device;

Figure 12 is a circuit diagram of a memory cell of the device of Figure 11;

Figure 13 is a circuit diagram of a bit line pre-charging circuit of the device of Figure 11;

Figure 14 is a circuit diagram of a bit line sensing circuit of the device of Figure 11;

Figure 15 is a circuit diagram of the pre-decoders of the device of Figure 11;

Figure 16 is a circuit diagram of the bit line control clock generator circuit of the device of Fig. 11;

Figure 17 is a circuit diagram of the address buffer of the device of Figure 11;

Figure 18 is a circuit diagram of the circuit for generating the pre-clock signals $PA_i$ (i=0 to 7) of the circuit shown in Figure 16;

Figs. 19A to 19E are timing diagrams for explaining the operation of the circuit of Fig. 16;

Figs. 20A and 20B are further circuit diagrams of the bit line control clock generator circuit of the device of Figure 11; and,

Figures 21A to 21E are timing diagrams for explaining the operation of the circuits of Figures 20A and 20B.

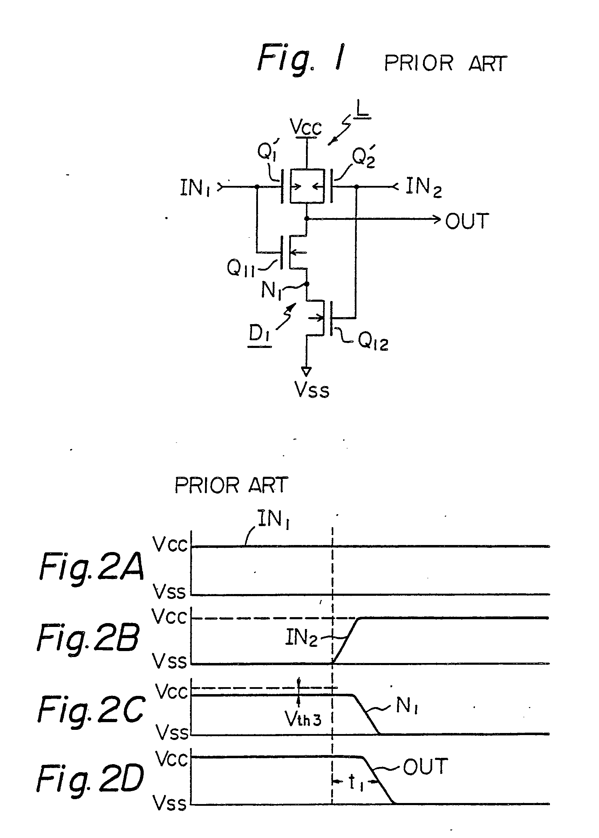

In Fig. 1, which illustrates a prior art two-input complementary metal-insulator-semiconductor (CMIS) NAND circuit, two P-channel transistors $Q_1'$ and $Q_2'$ are connected in parallel between a power supply $V_{cc}$ and an output terminal OUT to form a load L. The transistors $Q_1'$ and $Q_2'$ are driven by the potentials at input terminals $IN_1$ and $IN_2$, respectively. In addition, two N-channel transistors $Q_{11}$ and $Q_{12}$ are connected in series between a power supply $V_{ss}$, having a lower potential than the power supply $V_{cc}$, and the output terminal OUT to form a driver circuit $D_1$. The transistors $Q_{11}$ and $Q_{12}$ are also driven by the potentials at the input terminals $IN_1$ and $IN_2$, respectively. Note that the "apostrophe" on the references designates "P-channel type".

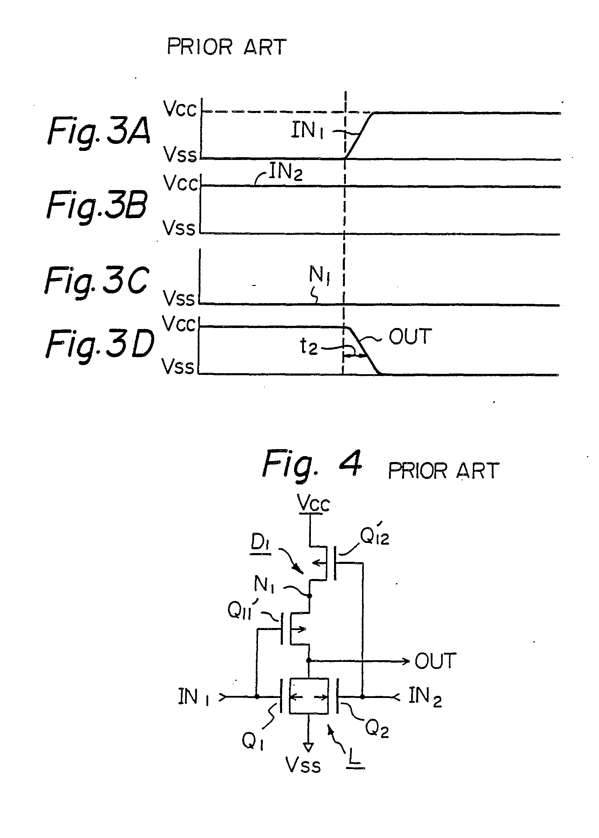

The operation of the circuit of Fig. 1 will now be explained with reference to Figs. 2A through 2D and Figs. 3A through 3D. As illustrated in Figs. 2A and 2B, when the potential at the input terminal $IN_1$ remains at $V_{cc}$ and, in addition, the potential at the input terminal $IN_2$ is changed from $V_{ss}$ to $V_{cc}$, the potential at the output terminal OUT is changed from $V_{cc}$ to $V_{ss}$, as illustrated in Fig. 2D. In this case, however, before the change of the potential at the input terminal $IN_2$, the transistors $Q_2'$ and $Q_{11}$ are both turned on and the transistors $Q_1'$ and $Q_{12}$ are turned off, so that a node $N_1$ connecting the transistor $Q_{11}$ to the transistor $Q_{12}$ is charged at $V_{cc}-V_{th3}$, where $V_{th3}$ is the threshold

voltage of the transistor $Q_{12}$, as illustrated in Fig. 2C. As a result, even when the potential at the input terminal $IN_2$ is changed from $V_{ss}$ to $V_{cc}$ so as to turn off the transistor $Q_2'$ and turn on the transistor $Q_{12}$, the potential at the output terminal OUT does not become $V_{ss}$ until the node $N_1$ is discharged, resulting in a relatively large delay time $t_1$.

On the other hand, as illustrated in Figs. 3A and 3B, when the potential at the input terminal $IN_2$ remains at $V_{cc}$ and, in addition, the potential at the input terminal $IN_1$ is changed from $V_{ss}$ to $V_{cc}$, the potential at the output terminal OUT is also changed from $V_{cc}$ to $V_{ss}$, as illustrated in Fig. 3D. That is, this operation is logically the same as the above-mentioned operation. In this case, before the change of the potential at the input terminal $IN_1$, the transistors $Q_1'$ and $Q_{12}$ are turned on and the transistors $Q_2'$ and $Q_{11}$ are turned off, so that the potential at the node $N_1$ is at $V_{ss}$, as illustrated in Fig. 3C. Therefore, when the potential at the input terminal $IN_1$ is changed from $V_{ss}$ to $V_{cc}$, so as to turn off the transistor $Q_1'$ and turn on the transistor $Q_{11}$, the potential at the node $N_1$ is changed with a relatively small delay time $t_2$, since it is unnecessary to discharge the node $N_1$.

Thus, a difference in speed between the operation as shown in Figs. 2A through 2D and the operation as shown in Figs. 3A through 3D is generated. This difference is inherent in the constitution of the series connection of the transistors $Q_{11}$ and $Q_{12}$.

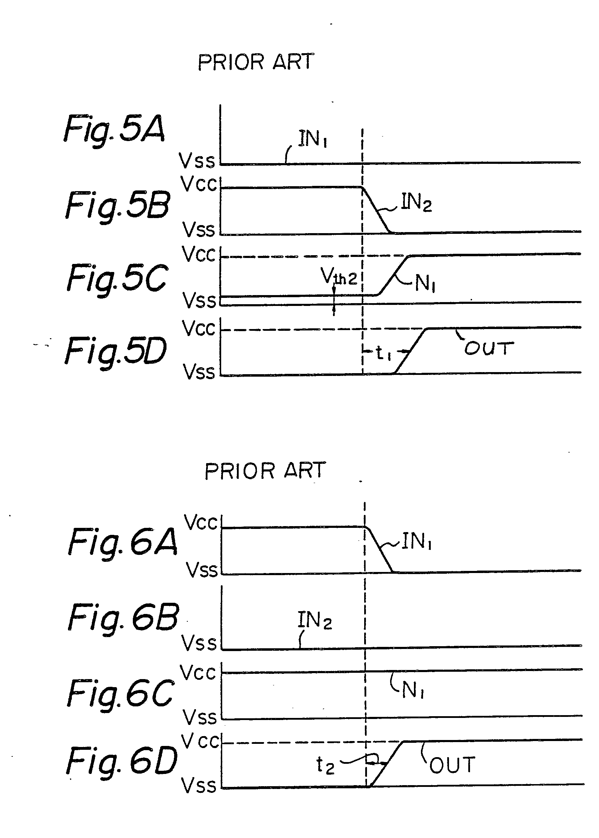

The above-mentioned difference in operation speed similarly occurs in the case of an NOR circuit as illustrated in Fig. 4, which illustrates a prior art two-input CMIS NOR circuit. In Fig. 4, two N-channel transistors $Q_1$ and $Q_2$ are connected in parallel between the power supply $V_{ss}$ and the output terminal OUT to form a load L, while two P-channel transistors $Q_{11}'$ and $Q_{12}'$ are connected in series between the power supply $V_{cc}$ and the output terminal OUT to form a driver circuit $D_1$. As illustrated in Figs. 5A through 5D, when the potential at the input terminal $IN_1$ remains at $V_{ss}$ and, in addition, the potential at the input terminal $IN_2$ is changed from $V_{cc}$ to $V_{ss}$, it is necessary to charge the node $N_1$, having the potential $V_{ss}+V_{th2}$, where $V_{th2}$ is the threshold voltage of the transistor $Q_{11}'$, whereby a relatively large delay time $t_1$ is generated. Contrary to this, as illustrated in Figs. 6A through 6D, when the potential at the input terminal $IN_2$ remains at $V_{ss}$ and, in addition, the potential at the input terminal $IN_1$ is changed from $V_{cc}$ to $V_{ss}$, it is unnecessary to charge the node $N_1$. As a result, a relatively small delay time $t_2$ is generated. Therefore, a difference in operation speed is generated between the operation as illustrated in Figs. 5A through 5D and the operation as illustrated in Figs. 6A through 6D.

In the present invention, the relatively large delay time $t_1$ is shortened so as to eliminate the above-mentioned difference in operation speed.

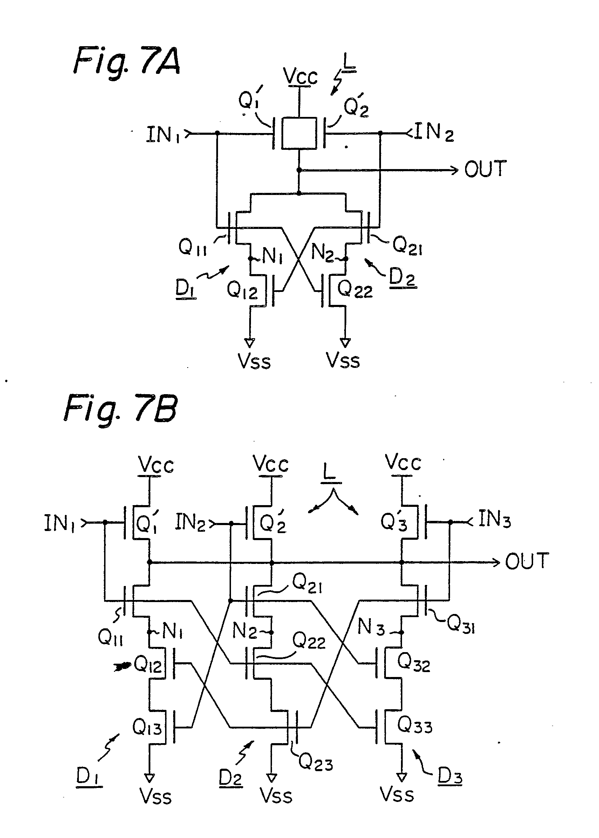

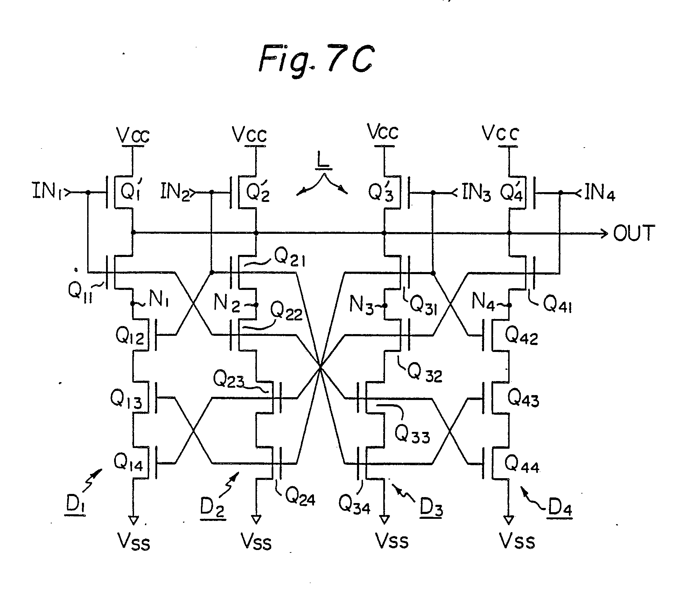

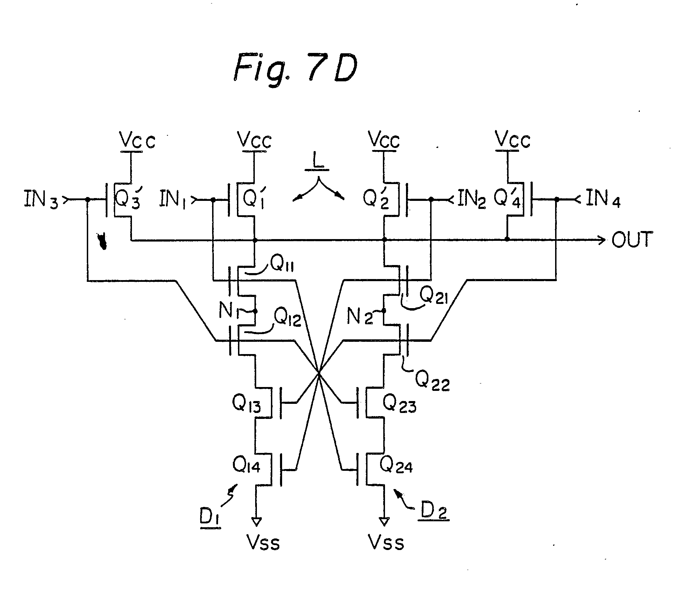

Figures 7A, 7B, and 7C illustrate first, second, and third embodiments of the present invention, i.e., a two-input CMIS NAND circuit, a three-input CMIS NAND circuit, and a four-input CMIS NAND circuit, respectively. Figure 7D illustrates a fourth embodiment of the present invention, also a four-input CMIS NAND circuit.

In the embodiment of Fig. 7A, two driver circuits $D_1$ and $D_2$ connected in parallel are provided. In the driver circuit $D_1$, a first N-channel transistor $Q_{11}$ connected directly to the output terminal OUT is driven by the potential at the input terminal $IN_1$, while a second N-channel transistor $Q_{12}$ is driven by the potential at the input terminal $IN_2$. In the driver circuit $D_2$, a first N-channel transistor $Q_{21}$ connected directly to the output terminal OUT is driven by the input terminal $IN_2$ and a second N-channel transistor $Q_{22}$ is driven by the input terminal $IN_1$.

When the potentials at the input terminals $IN_1$ and $IN_2$ are $V_{cc}$ and $V_{ss}$, respectively, the transistors $Q_2'$, $Q_{11}$, and $Q_{22}$ are turned on and the transistors $Q_1'$, $Q_{12}$, and $Q_{21}$ are turned off. As a result, the potential at the node $N_1$ is $V_{cc}-V_{th}$, and the potential at the node $N_2$ is $V_{ss}$. Therefore, when the potential at the input $IN_2$ is changed from $V_{ss}$ to $V_{cc}$, the transistor $Q_2'$ is turned off and the transistor $Q_{21}$ is turned on, so that the potential at the output terminal OUT is changed quickly from $V_{cc}$ to $V_{ss}$ under the influence of the discharged node $N_2$. Contrary to this, when the potential at the input terminal $IN_2$ remains at $V_{cc}$ and, in addition, the potential at the input terminal $IN_1$ is changed from $V_{ss}$ to $V_{cc}$, the potential at the output terminal OUT is also changed quickly from $V_{cc}$ to $V_{ss}$ under the influence of the discharged node $N_1$, in the same way as in Fig. 1. That is, in all cases, the operation time is $t_2$ as shown in Fig. 3D.

In the embodiment of Fig. 7B, three driver circuits $D_1$, $D_2$, and $D_3$ connected in parallel are provided. The structure of the circuit of Fig. 7B is similar to that of the circuit of Fig. 7A. That is, first N-channel transistors $Q_{11}$, $Q_{21}$, and $Q_{31}$ of the driver circuits connected directly to the output terminal OUT are driven by the potentials at the input terminals $IN_1$, $IN_2$, and $IN_3$, respectively. Therefore, when two of the potentials at the input terminals $IN_1$, $IN_2$, and $IN_3$ remain at $V_{cc}$ and the other potential remains at $V_{ss}$, the potential at only one of the nodes $N_1$, $N_2$, and $N_3$ remains at $V_{ss}$. For example, when the potentials at the input terminals $IN_1$ and $IN_2$ remain at $V_{cc}$, and the potential at the input terminal $IN_3$ remains at $V_{ss}$, the potential at only the node $N_3$ is $V_{ss}$. As a result, when the potential at the input terminal $IN_3$ is changed from $V_{ss}$ to $V_{cc}$, the potential at the output terminal OUT is changed quickly from $V_{cc}$ to $V_{ss}$ under the influence of the discharged node $N_3$.

In the embodiment of Fig. 7C, four driver circuits $D_1$, $D_2$, $D_3$, and $D_4$ connected in parallel are provided. The structure of the circuit of Fig. 7C is also similar to that of the circuit of Fig. 7A or 7B. That is, first N-channel transistors $Q_{11}$, $Q_{21}$, $Q_{31}$, and $Q_{41}$ of the driver circuits connected directly to the output terminal OUT are driven by the potentials at the input terminals $IN_1$, $IN_2$, $IN_3$, and $IN_4$, respectively. Therefore, when three of the potentials at the input terminals $IN_1$, $IN_2$, $IN_3$, and $IN_4$ remains at $V_{cc}$ and the other potential remains at $V_{ss}$, the potential at only one of the nodes $N_1$, $N_2$, $N_3$, and $N_4$ remains at $V_{ss}$. For example, when the potentials at the input terminals $IN_1$, $IN_2$, and $IN_3$ remain at $V_{cc}$, and the potential at the input terminal $IN_4$ remains at $V_{ss}$, the potential at only the node $N_4$ is $V_{ss}$. As a result, when the potential at the input terminal $IN_4$ is changed from $V_{ss}$ to $V_{cc}$, the potential at the output terminal OUT is changed quickly from $V_{cc}$ to $V_{ss}$ under the influence of the discharged node $N_4$.

In the embodiment of Fig. 7D, a four-input CMIS NAND circuit is illustrated, but only two driver circuits $D_1$ and $D_2$ are provided. In this case, the potentials at the input terminals $IN_1$ and $IN_2$ are more important than the potentials at the input terminals $IN_3$ and $IN_4$. That is, first N-channel transistors $Q_{11}$ and $Q_{21}$ of the driver circuits $D_1$ and $D_2$ connected directly to the output terminal OUT are driven by the potentials at the input terminals $IN_1$ and $IN_2$, respectively. Therefore, when the potential at input terminal $IN_1$ or $IN_2$ remains at $V_{ss}$ and the potentials at the other input terminals $V_{cc}$, the potential at the node $N_1$ or $N_2$ is $V_{ss}$. Therefore, when the potential at the input terminal $IN_1$ or $IN_2$ is changed from $V_{ss}$ to $V_{cc}$, the potential at the output terminal OUT is changed quickly from $V_{cc}$ to $V_{ss}$. However, when the potential at the input terminal $IN_3$ or $IN_4$ is changed from $V_{ss}$ to $V_{cc}$, the potential at the output terminal OUT cannot be changed quickly from $V_{cc}$ to $V_{ss}$. Therefore, the circuit of Fig. 7D is applied to specific input conditions.

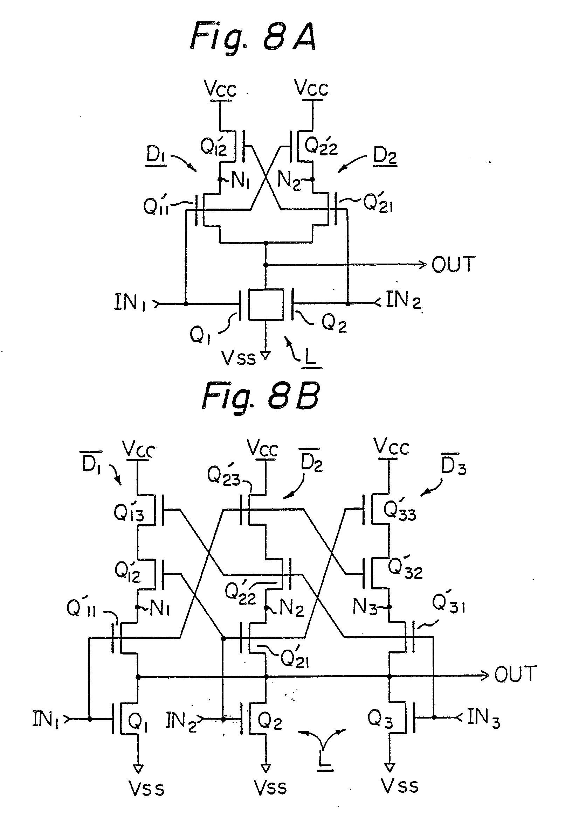

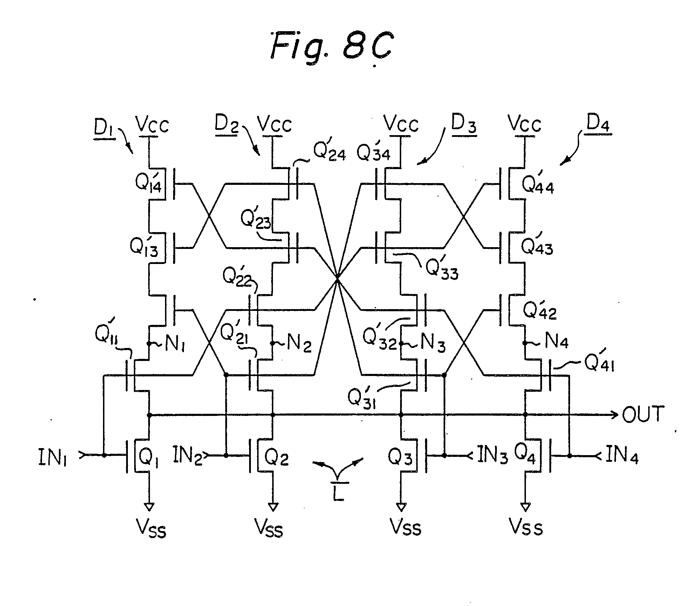

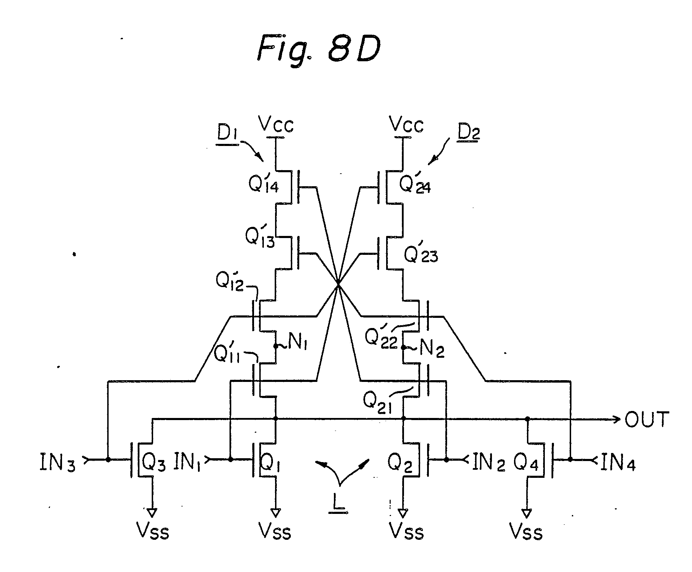

Figures 8A, 8B, 8C, and 8D illustrate fifth, sixth, seventh, and eighth embodiments of the present invention, i.e., CMIS NOR circuits. Note that the embodiments of Figs. 8A, 8B, 8C, and 8D roughly correspond to the embodiments of Figs. 7A, 7B, 7C, and 7D, respectively. For example, the circuits of 8A is the same as the circuit of Fig. 7A, the except load L and the driver circuits $D_1$ and $D_2$ are reversed in respect to the output terminal OUT and the P-channel transistors of the load L are changed to an N-channel type and vice versa.

The operation of the circuits of Figs. 8A, 8B, 8C, and 8D are similar to the operation of the circuits of Figs. 7A, 7B, 7C, and 7D, respectively. For example, in the embodiment of Fig. 8B, when two of the potentials at the input terminals $IN_1$, $IN_2$, and $IN_3$ remain at $V_{ss}$ and the other potential remains at $V_{cc}$, the potential at only one of the nodes $N_1$, $N_2$, and $N_3$ remains at $V_{cc}$. For example, when the potentials at the input terminals $IN_1$ and $IN_2$ remain at $V_{ss}$, and the potential at the input terminal $IN_3$ remains at $V_{cc}$, the potential at only the node $N_3$ is $V_{cc}$. As a result, when the potential at the input terminal $IN_3$ is changed from $V_{cc}$ to $V_{ss}$, the potential at the output terminal OUT is changed quickly from $V_{ss}$ to $V_{cc}$ under the influence of the charged node $N_3$.

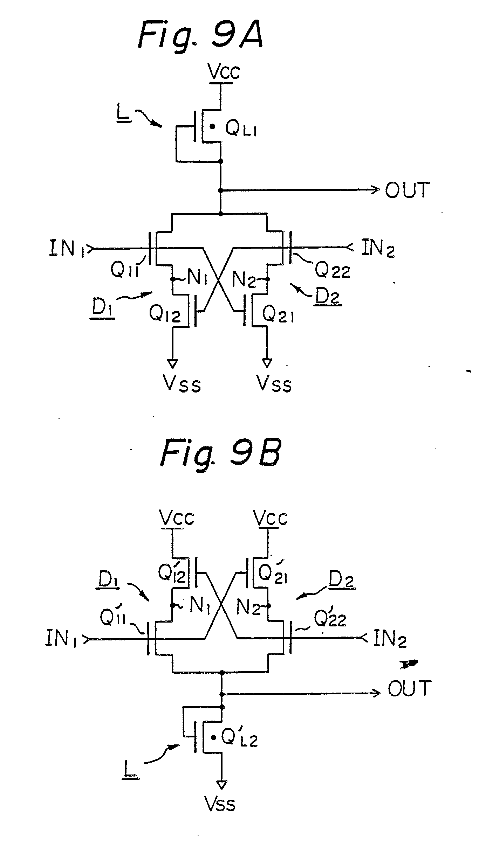

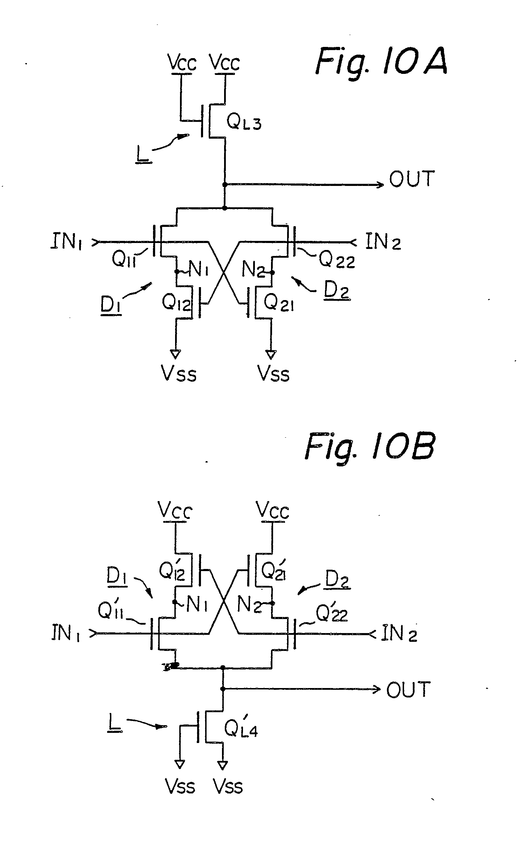

Figures 7A through 7D and Figs. 8A through 8D illustrate CMIS logic circuits. However, note that the present invention can be also applied to an enhancement/depletion (E/D) type MIS logic circuit and a conventional MIS logic circuit as is shown in Figures 9A, 9B, 10A and 10B.

In an E/D MIS logic circuit such as an E/D MIS NAND circuit as illustrated in Fig. 9A or an E/D MIS NOR circuit as illustrated in Fig. 9B, the load L is constructed by a depletion-type transistor $Q_{L1}$ (N-channel) or $Q_{L2}'$ (P-channel) in which the source and gate are connected to each other. On the other hand, in a conventional MIS logic circuit such as an NAND circuit as illustrated in Fig. 10A or an NOR circuit as illustrated in Fig. 10B, the load L is constructed by an enhancement-type transistor $Q_{L3}$ (N-channel) or $Q_{L4}'$ (P-channel) in which the drain and gate are connected to each other.

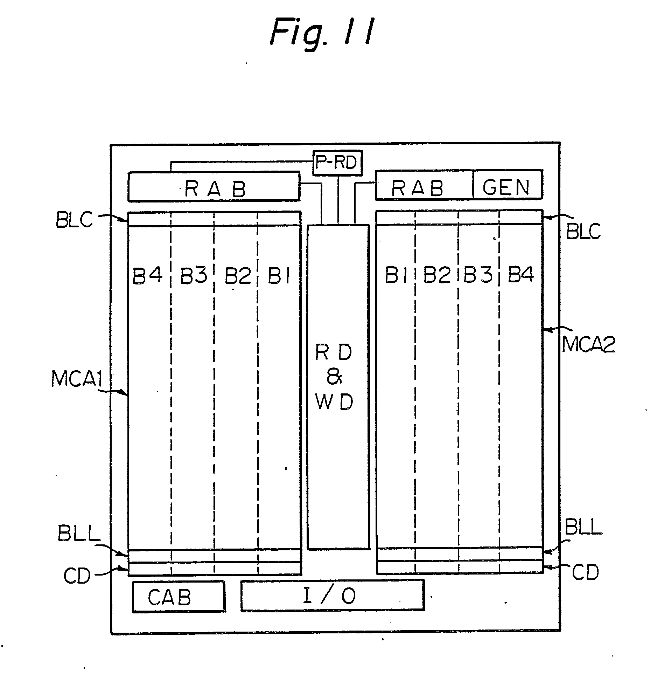

The application of the circuits according to the present invention will now be explained with reference to Fig. 11.

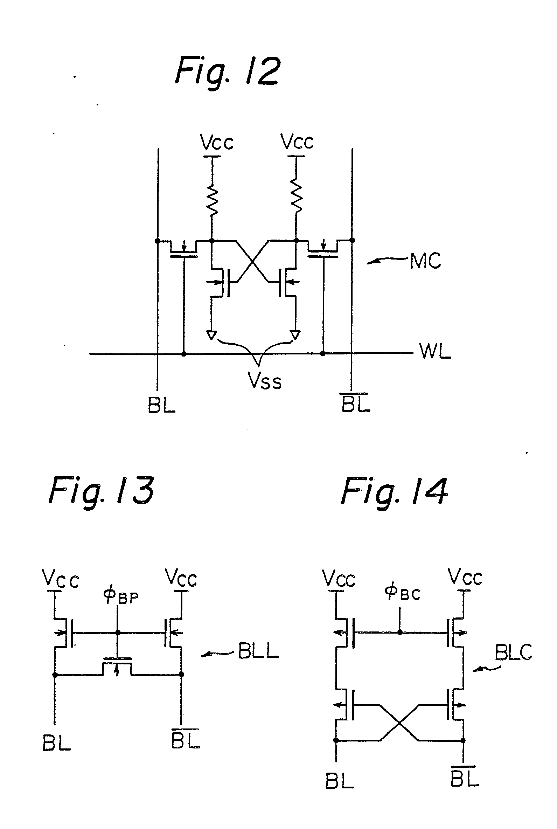

In Fig. 11, a 64 Kbit static random access memory (RAM) is illustrated. References MCA1 and MCA2 designate memory cell arrays formed by a large number of memory cells MC as illustrated in Fig. 12; RAB row address buffers; CAB column address buffers; I/O input/output circuits; GEN a bit line control clock generator circuit; P-RD pre-decoders; RD row decoders; WD word drivers; CD column decoders; BLL bit line precharging circuits as illustrated in Fig. 13; and BLC bit line sensing circuits as illustrated in Fig. 14.

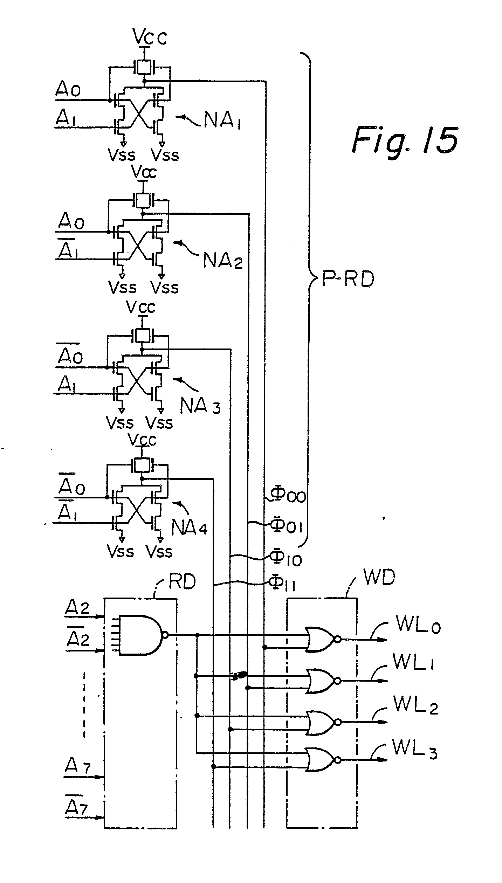

In a highly integrated large-capacity memory device, each memory cell MC is very small in size. Accordingly, the pitch between adjacent rows is also extremely narrow. Therefore, it is difficult to place one decoder for each row. In order to overcome this, one row decoder is allocated to every two or four word lines. For example, as illustrated in Fig. 15, the pre-decoders P-RD determine the selection modes $\Phi_{00}$, $\Phi_{01}$, $\Phi_{10}$, and $\Phi_{11}$. In the pre-decoders P-RD, four NAND circuits $NA_1$, $NA_2$, $NA_3$, and $NA_4$ of Fig. 7A are used.

The logic circuits according to the present invention can be also applied to the bit line control clock generator circuit GEN of Fig. 11, which will now be explained in more detail. One bit line precharging circuit and one bit line sensing circuit are provided for each bit line pair. That is, during the read mode, the bit line precharging circuits BLL are controlled by a clock signal $\Phi_{BP}$ from the bit line control clock generator circuit GEN to precharge the corresponding bit lines. After that, the bit lines become in a floating state. Next, one selected memory cell is connected to each bit line pair. As a result, the small difference in potential between the bit line pair is sensed or enlarged by the corresponding bit line sensing circuit BLC, which is controlled by a clock signal $\Phi_{BC}$ from the bit line control clock generator circuit GEN.

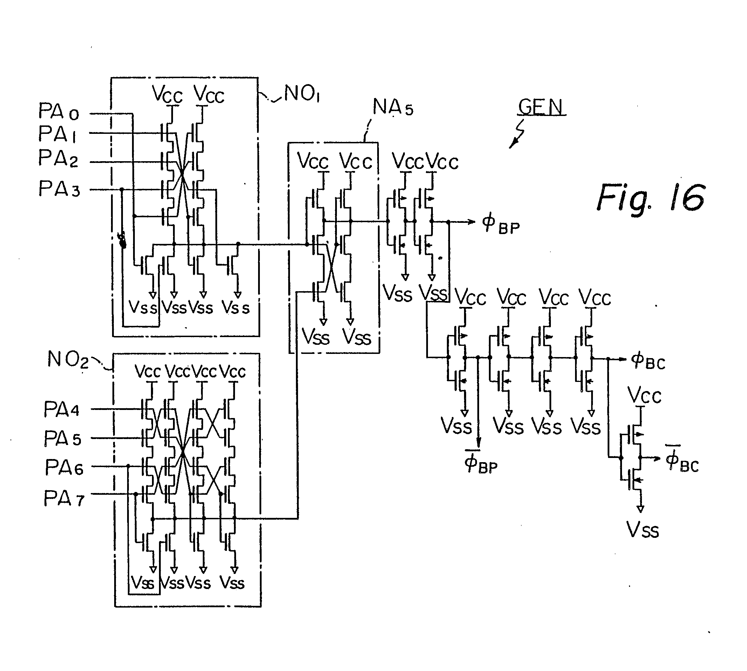

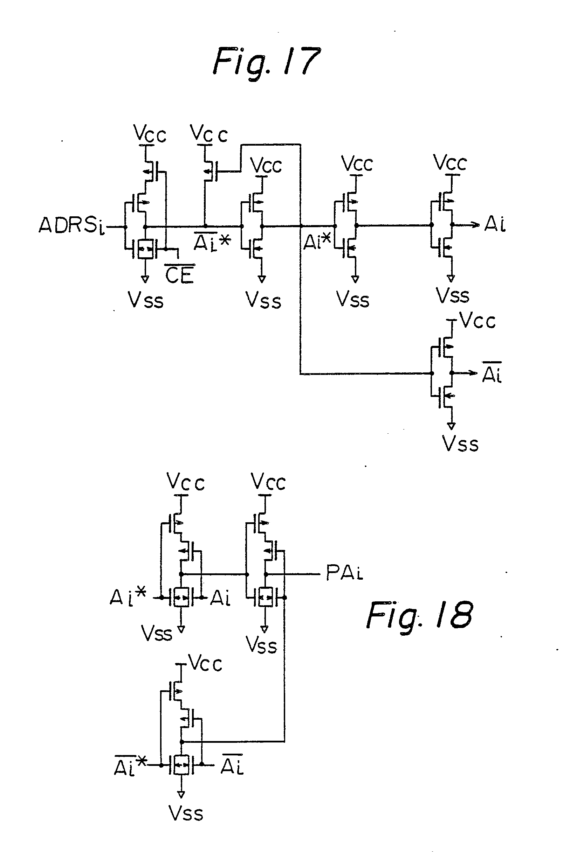

Figure 16 illustrates one example of the bit line control clock generator circuit GEN of Fig. 11. In Fig. 16, the generator circuit GEN comprises a NOR circuit $NO_1$ of Fig. 8D, a NOR circuit $NO_2$ of Fig. 8C, a NAND circuit $NA_5$ of Fig. 7A, and a plurality of inverters. Row address pre-clock

signal $PA_0$ through $PA_7$ correspond to external row address signals $ADRS_i$ (i=0 to 7), respectively. For example, when the row address signal $ADRS_0$ changes, the row address pre-clock signal $PA_0$ remains at a high level for a definite time. Otherwise, the signal $PA_0$ always remains at a low level. Such pre-clock signals $PA_0$ through $PA_7$ are obtained by the circuits of Figs. 17 and 18. Note that $\overline{CE}$ of Fig. 17 designates a memory control signal. The circuits $NO_1$, $NO_2$, and $NA_5$ of Fig. 16 together constitute a circuit for detecting the change of row address signals.

Note that the NOR circuit $NO_1$ comprises only two loads, since, in this case, the signals $PA_0$ and $PA_1$ corresponding to the row address signals $A_0$ and $A_1$ are more important than the signals $PA_2$ and $PA_3$ corresponding to the row address signals $A_2$ and $A_3$.

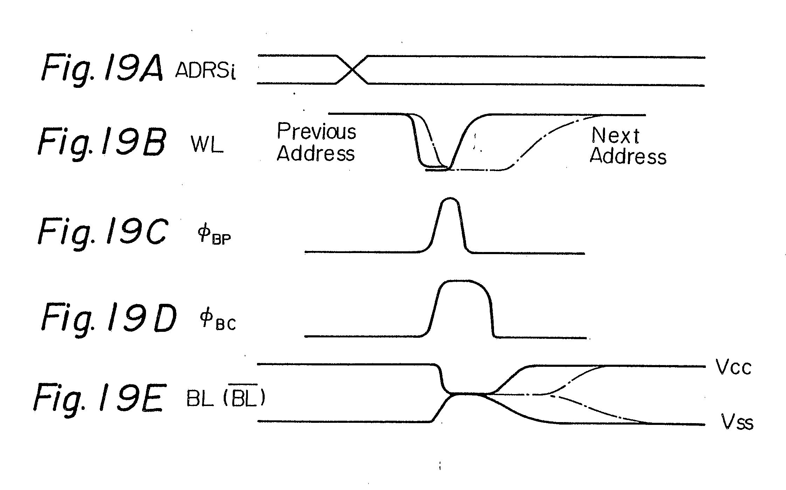

As illustrated in Fig. 19A, when at least one of the row address signals $PA_0$ through $PA_3$ changes, the output of the NOR circuit $NO_1$ reaches a high level. Similarly, when at least one of the row address signals $PA_4$ through $PA_7$ changes, the output of the NOR circuit $NO_1$ reaches a high level. In all cases, the output of the NAND circuit $NA_5$ reaches a high level. As a result, the clock signal $\phi_{BP}$ changes as illustrated in Fig. 19C, and the clock signal $\phi_{BC}$ changes as illustrated in Fig. 19D. Therefore, the bit line sensing circuit BLC does not perform a sensing operation for the precharging operation mode and for a definite time after the precharging operation is completed. As a result, the potentials at the bit lines change as illustrated in Fig. 19E.

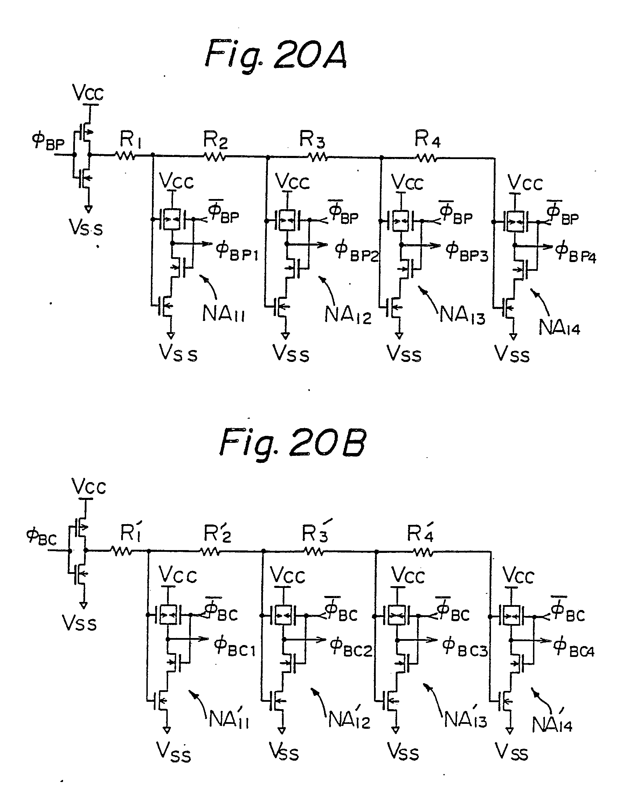

Generally, the connections between the generator circuit GEN and the circuits BLL and BLC are formed by aluminum, which has a small delay time, while the word line WL is formed by polycrystalline silicon, which has a large delay time. As a result, the potential at the portion of a word line far from the word drivers WD changes slower than the portion of the word line near the word drivers WD. The change of the former is illustrated by a dot and dash line in Fig. 19B. In this case, the change of the potentials of the bit lines is illustrated by a dot and dash line in Fig. 19E. Therefore, it is necessary to delay the clock signals $\phi_{BP}$ and $\phi_{BC}$ in accordance with the delay of the change of the word line portion. For this purpose, the circuits of Figs. 20A and 20B are added to the circuit of Fig. 16.

In the combination of the circuits of Figs. 16, 20A, and 20B, four kinds of bit line control clock signals $\phi_{BP1}$, $\phi_{BP2}$, $\phi_{BP3}$, and $\phi_{BP4}$ are generated for four blocks B1, B2, B3, and B4 of the memory cell arrays MCA1 and MCA2, respectively. In addition, four kinds of bit line sensing clock signals $\phi_{BC1}$, $\phi_{BC2}$, $\phi_{BC3}$, and $\phi_{BC4}$ are generated for the blocks B1, B2, B3, and B4, respectively.

For example, the circuit of Fig. 20A comprises four resistors $R_1$, $R_2$, $R_3$, and $R_4$ and four NAND circuits $NA_{11}$, $NA_{12}$, $NA_{13}$, and $NA_{14}$. However, these NAND circuits do not always require two driver circuits, since the sequence of the input conditions for the NAND circuits is definite. In Fig.

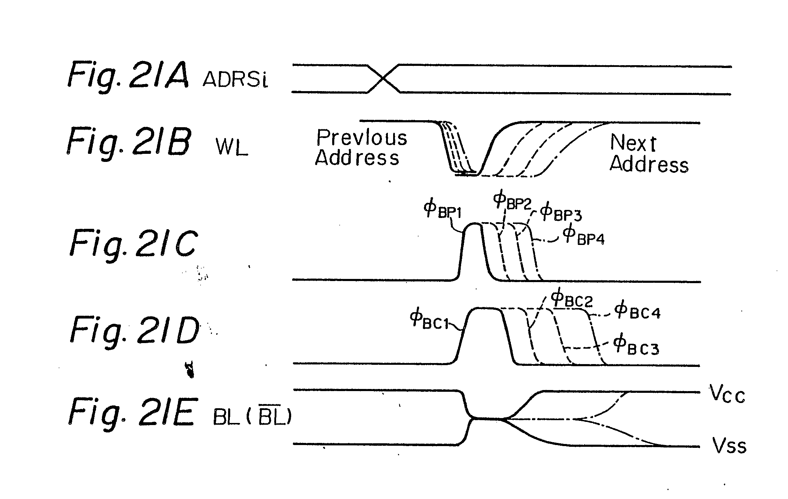

20A, when the potential of the signal $\phi_{BP}$ is changed from a low level to a high level and, accordingly, the potential of the signal $\overline{\phi_{BP}}$ is changed from a high level to a low level, the potentials of the signals $\phi_{BP1}$, $\phi_{BP2}$, $\phi_{BP3}$, and $\phi_{BP4}$ rise simultaneously, as illustrated in Fig. 21C. Contrary to this, when the potential of the signal $\phi_{BP}$ is changed from a high level to a low level and, accordingly, the potential of the signal $\overline{\phi_{BP}}$ is changed from a low level to a high level, the signals $\phi_{BP1}$, $\phi_{BP2}$, $\phi_{BP3}$, and $\phi_{BP4}$ fall in this order due to the presence of the delay circuits.

Similarly, the potentials of the clock signals $\phi_{BC1}$, $\phi_{BC2}$, $\phi_{BC3}$, and $\phi_{BC4}$ change in the same way as those of the clock signals $\phi_{BP1}$, $\phi_{BP2}$, $\phi_{BP3}$, and $\phi_{BP4}$, except for the delay times of the fall of the potentials, as illustrated in Fig. 21D. Thus, the delay time of each block B1, B2, B3, and B4 of the memory cell arrays MCA1 and MCA2 can be compensated. In this case, note that it is not important that the potentials of the signals $\phi_{BP1}$ through $\phi_{BP4}$ rise simultaneously. In other words, the signals $\overline{\phi_{BC, i+1}}$ can be also obtained by shifting the signal $\phi_{BCi}$. Note that Figs. 21A, 21B, and 21E are the same as Figs. 19A, 19B, and 19E, respectively.

As explained hereinbefore, according to the present invention, no fluctuation in operation speed is generated regardless of the condition of the input signals. In addition, the operation speed is increased.

## Claims

1. A logic circuit comprising a first power supply ($V_{cc}$ or $V_{ss}$); a second power supply ($V_{ss}$ or $V_{cc}$); a plurality of input terminals ($IN_1$, $IN_2$, . . .); an ouput terminal (OUT); a load means (L) connected between the first power supply and the output terminal; and at least two driver circuits ($D_1$, $D_2$, . . .) connected in parallel between the second power supply and the output terminal, each of the driver circuits comprising a plurality of transistors ($Q_{11}$, $Q_{12}$, . . . or $Q_{11}'$, $Q_{12}'$ . . .) of the same polarity connected in series, and each of the transistors being driven by the potential at one of the input terminals, wherein transistors ($Q_{11}$, $Q_{21}$, . . . or $Q_{11}'$, $Q_{21}'$) of the driver circuits connected directly to the output terminal are driven by the potentials at different input terminals, characterised in that the number of transistors ($Q_{11}$, $Q_{12}$, . . . or $Q_{11}'$, $Q_{12}'$ . . .) in each driver circuit ($D_1$, $D_2$ . . .) is the same as the number of input terminals ($IN_1$, $IN_2$, . . .); in that each input terminal ($IN_1$, $IN_2$, . . .) is connected to transistors ($Q_{11}$, $Q_{12}$, . . .; $Q_{11}'$, $Q_{12}'$ . . .) in at least two driver circuits ($D_1$, $D_2$ . . .) at different positions in the driver circuits; and in that each driver circuit ($D_1$, $D_2$ . . .) provides the same logic response to potentials at the input terminals ($IN_1$, $IN_2$ . . .).

2. A logic circuit according to claim 1, wherein each of the transistors comprises an N-channel enhancement-type transistor ($Q_{11}$ to $Q_{14}$, . . .), the potential of the first power supply ($V_{cc}$) being higher than that of the second power supply ($V_{ss}$).

3. A logic circuit according to claim 2, wherein the load means (L) comprises a plurality of P-channel enhancement-type transistors ($Q_1'$ to $Q_2'$) each driven by a respective one of the potentials at the input terminals ($IN_1$, $IN_2$ ...).

4. A logic circuit according to claim 2, wherein the load means (L) comprises an N-channel depletion-type transistor ($Q_{L1}$) having a drain connected to the first power supply ($V_{cc}$), and having a gate connected to the source thereof and to the output terminal (OUT).

5. A logic circuit according to claim 2, wherein the load means (L) comprises an N-channel enhancement transistor ($Q_{L3}$) having a drain connected to the gate thereof and to the first power supply ($V_{cc}$), and having a source connected to the output terminal (OUT).

6. A logic circuit according to claim 1, wherein each of the transistors comprises a P-channel enhancement-type transistor ($Q_{11}'$ to $Q_{14}'$, ...), the potential of the first power supply ($V_{ss}$) being lower than that of the second power supply ($V_{cc}$).

7. A logic circuit according to claim 6, wherein the load means (L) comprises a plurality of N-channel enhancement-type transistors ($Q_1$ to $Q_4$) each driven by a respective one of the potentials at the input terminals ($IN_1$, $IN_2$, ...).

8. A logic circuit according to claim 6, wherein the load means (L) comprises a P-channel depletion-type transistor ($Q_{L2}'$) having a drain connected to the first power supply ($V_{ss}$), and having a gate connected to the source thereof and to the output terminal (OUT).

9. A logic circuit according to claim 6, wherein the load means (L) comprises a P-channel enhancement transistor ($Q_{L4}'$) having a drain connected to the gate thereof and to the first power supply ($V_{ss}$), and having a source connected to the output terminal (OUT).

10. A memory device including logic circuits in accordance with any of the preceding claims.

## Patentansprüche

1. Logikschaltung mit einer ersten Energieversorgung ($V_{cc}$ oder $V_{ss}$); einer zweiten Energieversorgung ($V_{ss}$ oder $V_{cc}$); einer Anzahl von Eingangsanschlüssen ($IN_1$, $IN_2$, ...); einem Ausgangsanschluß (OUT); einer Lasteinrichtung (L), die zwischen der ersten Energieversorgung und dem Ausgangsanschluß angeschlossen ist; und wenigstens zwei Treiberschaltungen ($D_1$, $D_2$, ...), die parallel zwischen der zweiten Energieversorgung und dem Ausgangsanschluß verbunden sind, wobei jede der Treiberschaltungen eine Anzahl von Transistoren ($Q_{11}$, $Q_{12}$, ... oder $Q_{11}'$, $Q_{12}'$ ...) von derselben Polarität und in Reihe geschaltet umfaßt und jeder der Transistoren durch das Potential bei einem der Ansgangsanschlüsse getrieben wird, wobei die Transistoren ($Q_{11}$, $Q_{21}$, ... oder $Q_{11}'$, $Q_{21}'$) der Treiberschaltungen, die direkt mit dem Ausgangsanschluß verbunden sind, durch die Potentiale an verschiedenen Eingangsanschlüssen getrieben werden, dadurch gekennzeichnet, daß die Anzahl der Transistoren ($Q_{11}$, $Q_{12}$, ... oder $Q_{11}'$, $Q_{12}'$ ...) in jeder Treiberschaltung ($D_1$, $D_2$ ...) die gleiche ist wie die Anzahl der Eingangsanschlüsse ($IN_1$, $IN_2$, ...); und daß jeder Eingangsanschluß ($IN_1$, $IN_2$, ...) mit den Transistoren ($Q_{11}$, $Q_{12}$, ...; $Q_{11}'$, $Q_{12}'$ ...) in wenigstens zwei Treiberschaltungen ($D_1$, $D_2$ ...) an verschiedenen Positionen in den Treiberschaltungen verbunden ist; und daß jede Treiberschaltung ($D_1$, $D_2$ ...) dieselbe logische Antwort auf Potentiale bei den Eingangsanschlüssen ($IN_1$, $IN_2$ ...) liefert.

2. Logikschaltung nach Anspruch 1, bei welcher jeder der Transistoren einen N-Kanal-Transistor ($Q_{11}$ bis $Q_{14}$, ...) vom Anreicherungstyp umfaßt, und das Potential der ersten Energieversorgung ($V_{cc}$) höher als das der zweiten Energieversorgung ($V_{ss}$) ist.

3. Logikschaltung nach Anspruch 2, bei welcher die Lasteinrichtung (L) eine Anzahl von P-Kanal-Transistoren ($Q_1'$ bis $Q_2'$) vom Anreicherungstyp umfaßt, die durch ein entsprechendes der Potentiale an den Eingangsanschlüssen ($IN_1$, $IN_2$ ...) getrieben werden.

4. Logikschaltung nach Anspruch 2, bei welcher die Lasteinrichtung (L) einen N-Kanal-Transistor ($Q_{L1}$) vom Verarmungstyp umfaßt, dessen Drain mit der ersten Energieversorgung ($V_{cc}$) und dessen Gate mit seiner Source und dem Ausgangsanschluß (OUT) verbunden ist.

5. Logikschaltung nach Anspruch 2, bei welcher die Lasteinrichtung (L) einen N-Kanal-Transistor ($Q_{L3}$) vom Anreicherungstyp umfaßt, der ein Drain hat, das mit seinem Gate und mit der ersten Energieversorgung ($V_{cc}$) verbunden ist, und der eine Source hat, die mit dem Ausgangsanschluß (OUT) verbunden ist.

6. Logikschaltung nach Anspruch 1, bei welcher jeder der Transistoren einen P-Kanal-Transistor ($Q_{11}'$ bis $Q_{14}'$, ...) vom Anreicherungstyp umfaßt, und das Potential der erste Energieversorgung ($V_{ss}$) niedriger als das der zweiten Energieversorgung ($V_{cc}$) ist.

7. Logikschaltung nach Anspruch 6, bei welcher die Lasteinrichtung (L) eine Vielzahl von N-Kanal-Transistoren ($Q_1$ bis $Q_4$) vom Anreicherungstyp umfaßt, die jeweils von einem entsprechenden der Potentiale an den Eingangsanschlüssen ($IN_1$, $IN_2$, ...) getrieben werden.

8. Logikschaltung nach Anspruch 6, bei welcher die Lasteinrichtung (L) einen P-Kanal-Transistors ($Q_{L2}'$) vom Verarmungstyp umfaßt, der ein Drain hat, das mit der ersten Energieversorgung ($V_{ss}$) verbunden ist, und der ein Gate hat, das mit seiner Source und mit dem Ausgangsanschluß (OUT) verbunden ist.

9. Logikschaltung nach Anspruch 6, bei welcher die Lasteinrichtung (L) einen P-Kanal-Transistor ($Q_{L4}'$) vom Anreicherungstyp umfaßt, der ein Drain hat, das mit seinem Gate und der ersten Energieversorgung ($V_{ss}$) verbunden ist, und der eine Source hat, die mit dem Ausgangsanschluß (OUT) verbufden ist.

10. Speichereinrichtung mit Logikschaltungen nach einem der vorhergehenden Ansprüche.

## Revendications

1. Circuit logique comprenant une première source d'alimentation électrique ($V_{cc}$ ou $V_{ss}$); une deuxième source d'alimentation électrique ($V_{ss}$ ou $V_{cc}$); une pluralité de bornes d'entrée ($IN_1$, $IN_2$, ...); une borne de sortie (OUT); un moyen de charge (L) connecté entre la première alimentation électrique et la borne de sortie; et au moins deux circuits d'excitation ($D_1$, $D_2$, ...) connectés en parallèle entre la deuxième source d'alimentation électrique et la borne de sortie, chacun des circuits d'excitation comprenant plusieurs transistors ($Q_{11}$, $Q_{12}$, ... ou $Q'_{11}$, $Q'_{12}$, ...) de même polarité connectés en série, et chacun des transistors étant excité par le potentiel présent sur l'une des bornes d'entrée, où les transistors ($Q_{11}$, $Q_{21}$, ... ou $Q'_{11}$, $Q'_{21}$) des circuits d'excitation connectés directement à la borne de sortie sont excités par les potentiels existant sur différentes bornes d'entrée, caractérisé en ce que le nombre de transistors ($Q_{11}$, $Q_{12}$, ... ou $Q'_{11}$, $Q'_{12}$, ...) de chaque circuit d'excitation ($D_1$, $D_2$, ...) est le même que le nombre de bornes d'entrée ($IN_1$, $IN_2$, ...); en ce que chaque borne d'entrée ($IN_1$, $IN_2$, ...) est connectée à des transistors ($Q_{11}$, $Q_{12}$, ...; $Q'_{11}$, $Q'_{12}$, ...) d'au moins deux circuits d'excitation ($D_1$, $D_2$, ...) en différentes positions dans les circuits d'excitation; et ce que chaque circuit d'excitation ($D_1$, $D_2$, ...) fournit la même réponse logique à des potentiels présents sur les bornes d'entrée ($IN_1$, $IN_2$, ...).

2. Circuit logique selon la revendication 1, où chacun des transistors comprend un transistor du type enrichissement à canal N ($Q_{11}$ à $Q_{14}$, ...), le potentiel de la première alimentation électrique ($V_{cc}$) étant supérieur à celui de la deuxième alimentation électrique ($V_{ss}$).

3. Circuit logique selon la revendication 2, où le moyen de charge (L) comprend plusieurs transistors du type enrichissement à canal P ($Q'_1$ à $Q'_2$) qui sont excités chacun par l'un respectif des potentiels présents sur les bornes d'entrée ($IN_1$, $IN_2$, ...).

4. Circuit logique selon la revendication 2, où le moyen de charge (L) comprend un transistor du type appauvrissement à canal N ($Q_{L1}$) dont le drain est connecté à la première alimentation électrique ($V_{cc}$) et dont la grille est connectée à la source et à la borne de sortie (OUT).

5. Circuit logique selon la revendication 2, où le moyen de charge (L) comprend un transistor du type enrichissement à canal N ($Q_{L3}$) dont le drain est connecté à la grille et à la première alimentation électrique ($V_{cc}$) et dont la source est connectée à la borne de sortie (OUT).

6. Circuit logique selon la revendication 1, où chacun des transistors comprend un transistor du type enrichissement à canal P ($Q'_{11}$ à $Q'_{14}$, ...), le potentiel de le première alimentation électrique ($V_{ss}$) étant inférieur à celui de la deuxième alimentation électrique ($V_{cc}$).

7. Circuit logique selon la revendication 6, où le moyen de charge (L) comprend plusieurs transistors du type enrichissement à canal N ($Q_1$ à $Q_4$) qui sont excités chacun par l'un respectif des potentiels présents sur les bornes d'entrée ($IN_1$, $IN_2$, ...).

8. Circuit logique selon la revendication 6, où le moyen de charge (L) comprend un transistor du type appauvrissement à canal P ($Q'_{L2}$) dont le drain est connecté à la première alimentation électrique ($V_{ss}$) et dont la grille est connectée à la source et à la borne de sortie (OUT).

9. Circuit logique selon la revendication 6, où le moyen de charge (L) comprend un transistor du type enrichissement à canal P ($Q'_{L4}$) dont le drain est connecté à la grille et à la première alimentation électrique ($V_{ss}$) et dont la source est connectée à la borne de sortie (OUT).

10. dispositif de mémoire comportant des circuits logiques selon l'une quelconque des revendications précédentes.

0 083 482

Fig. 1    PRIOR ART

PRIOR ART

Fig.2A

Fig.2B

Fig.2C

Fig.2D

1

PRIOR ART

*Fig.3A*

*Fig.3B*

*Fig.3C*

*Fig.3D*

*Fig. 4* PRIOR ART

PRIOR ART

*Fig.5A*

*Fig.5B*

*Fig.5C*

*Fig.5D*

PRIOR ART

*Fig.6A*

*Fig.6B*

*Fig.6C*

*Fig.6D*

## Fig. 7A

## Fig. 7B

4

# Fig. 7C

# Fig. 7D

## *Fig. 8A*

## *Fig. 8B*

# Fig. 8C

# Fig. 8D

# Fig. 9A

# Fig. 9B

## Fig. 10A

## Fig. 10B

# Fig. 11

# Fig. 12

# Fig. 13

# Fig. 14

*Fig. 15*

Fig. 16

0 083 482

# Fig. 17

# Fig. 18

Fig.19A ADRSi

Fig.19B WL

Previous
Address

Next
Address

Fig.19C $\phi_{BP}$

Fig.19D $\phi_{BC}$

Fig.19E BL ($\overline{BL}$)

Vcc

Vss

0 083 482

## Fig. 20A

## Fig. 20B

Fig. 21A  ADRSi

Fig. 21B  WL

Previous Address

Next Address

Fig. 21C

$\phi_{BP1}$  $\phi_{BP2}$  $\phi_{BP3}$  $\phi_{BP4}$

Fig. 21D

$\phi_{BC1}$  $\phi_{BC2}$  $\phi_{BC4}$  $\phi_{BC3}$

Fig. 21E  BL ($\overline{BL}$)

Vcc

Vss

0 083 482

19